# EUROPÄISCHE PATENTSCHRIFT

(11) **EP 2 173 645 B1**
(45) Veröffentlichungstag und Bekanntmachung des Hinweises auf die Patenterteilung: **30.05.2012**
(21) Anmeldenummer: 08775255.6
(22) Anmeldetag: 21.07.2008
(51) Int. Cl.: B65G 51/03, H01L 21/677

(54) **ANORDNUNG ZUM BERÜHRUNGSLOSEN TRANSPORT VON FLACHEN SUBSTRATEN**
ARRANGEMENT FOR THE CONTACTLESS TRANSPORT OF FLAT SUBSTRATES
DISPOSITIF DESTINE AU TRANSPORT SANS CONTACT DE SUBSTRATS PLATS

(30) Priorität: 19.07.2007 DE 102007033944
(43) Veröffentlichungstag der Anmeldung: 14.04.2010
(73) Patentinhaber: Centrotherm Thermal Solutions GmbH + CO. KG, 89143 Blaubeuren (DE)
(72) Erfinder: VOELK, Hans-Peter, 89608 Griesingen (DE); HARTUNG, Robert Michael, 89143 Blaubeuren (DE)
(74) Vertreter: Lippert, Stachow & Partner
(86) Internationale Anmeldenummer: PCT/EP2008/059530
(87) Internationale Veröffentlichungsnummer: WO 2009/010592

(56) Entgegenhaltungen:
- DE-A1- 2 551 567
- DE-A1- 2 644 055

## Beschreibung

Die Erfindung betrifft eine Anordnung zum berührungslosen Transport von flachen Substraten, insbesondere von quadratischen oder eckigen Platten hoher Bruchempfindlichkeit, entlang eines Transportweges.

Die beispielsweise durch beheizte Prozesskammern zu transportierenden Substrate können aus Platten aus beliebigen hinreichend biegesteifen aber sehr bruchempfindlichen Materialien, wie Glas, Silizium oder Graphit, bestehen. Es ist daher sinnvoll, für den Transport derartiger Substrate nahezu berührungslose Transportsysteme einzusetzen.

Aus der DE 26 44 055 A1 ist ein geschlossenes System für den Transport von Halbleiterscheiben mittels eines gasförmigen Transportmediums zu und von Bearbeitungsstationen bekannt geworden. Das Transportmedium ist selbst zentrierend, so dass die Halbleiterscheiben immer mittig entlang des Transportweges transportiert werden. Dazu wird unter den Halbleiterscheiben ein Gaspolster mit gerichteten Kräften zur Zentrierung und Vorwärtsbewegung mittels halbkreisförmiger Gasdüsen erzeugt. Das Stoppen von Bewegungen erfolgt hier mittels Vakuum-Stoppeinrichtungen, welche die Halbleiterscheiben an den vorgesehenen Stellen vorübergehend fixieren.

Die DE 25 51 567 A1 offenbart eine Transportvorrichtung zum berührungslosen Transport von Substratscheiben auf der Basis des Bernoullischen Prinzips, wobei entlang des Transportweges hintereinander in Transportrichtung schräg angestellte Düsen vorgesehen sind. Diese Düsen erzeugen nach dem Bernoullischen Prinzip einen richtungsbestimmten Luft- oder Gasstrom.

Der Erfindung liegt die Aufgabe zugrunde, eine Anordnung zum berührungslosen Transport von flachen Substraten zu schaffen, mit der die Substrate auch Überkopf sicher beschleunigt, transportiert und wieder abgebremst werden können und zwar unabhängig von der Umgebungsatmosphäre und Umgebungstemperatur.

Die der Erfindung zugrunde liegende Aufgabe wird durch die kennzeichnenden Merkmale des Hauptanspruchs gelöst. Weitere Ausgestaltungen der Erfindung gehen aus den zugehörigen Unteransprüchen hervor.

Die erfindungsgemäße Anordnung nutzt den an sich bekannten Bernoulli-Effekt.

Dazu ist eine Mehrzahl von Bernoulli-Greifern beidseitig eines Transportweges abstandsweise hintereinander angeordnet und zwar derart, dass sich die Bernoulli-Greifer quer zur Transportrichtung paarweise gegenüberliegen, wobei die zu transportierenden Substrate bei deren Vorbeibewegung derart über den Bernoulli-Greifern positionierbar sind, dass diese beidseitig des Transportweges jeweils nur teilweise überdeckt sind, dass die Bernoulli-Greifer jeweils einen rechts- oder links spiralig aufwärts drehenden zum Substrat und in Transportrichtung gerichteten Gasstrom mit einer Drehachse senkrecht zur Unterlage erzeugen, wobei die Bernoulli-Greifer eines Paares jeweils einen unterschiedlich drehenden Gasstrom erzeugen und dass beidseitig des Transportweges mechanische Seitenführungselemente vorgesehen sind.

Mit der Erfindung ist es problemlos möglich, auch texturierte Substrate/Wafer auf der texturierten Seite zu greifen und zu transportieren, auch über Kopf.

Als die Seitenführungselemente kommen Schienen oder Begrenzungsleisten in Betracht.

In Fortführung der Erfindung sind die beidseitig längs des Transportweges aufeinander folgenden Bernoulli-Greifer abwechselnd zur Ausbildung von rechts oder links drehenden Gasströmen ausgebildet. Damit kann durch Ansteuerung jedes jeweils zweiten Paares mit einem Gas eine Transportrichtung und durch Ansteuerung der anderen jeweils zweiten Paare von Bernoulli-Greifern mit einem Gas eine entgegen gesetzte Transportrichtung realisiert werden. Auch eine Umkehr der Transportrichtung lässt sich dadurch realisieren, indem die Bernoulli-Greifer entsprechend angesteuert werden.

In einer Variante der Erfindung ist jeder Bernoulli-Greifer derart in der Strömungsrichtung des Gases umschaltbar, dass nacheinander rechts und links drehende Gasströmungen erzeugbar sind.

In einer weiteren Ausgestaltung der Erfindung sind am Ende des Transportweges Bernoulli-Greifer mit einer den übrigen Bernoulli-Greifern entgegen gesetzten Vortriebsrichtung angeordnet. Auf diese Weise lässt sich zum Ende des Transportweges eine Bremswirkung auf die transportierten Substrate erzielen.

Die Bernoulli-Greifer können entlang des Transportweges auf einer flächigen Unterlage angeordnet, oder in diese flächenbündig eingelassen bzw. eingepresst sein.

Um einen sicheren Transport der Substrate auch bei höheren Temperaturen, oder unter aggressiven Medien, zu gewährleisten, kann die Unterlage ggf. einschließlich der Bernoulli-Greifer auch vollkommen aus Graphit bestehen. Die Greifer können auch bei Temperaturen um 1000 °C und auch in einer H₂-Atmosphäre betrieben werden. Hierbei können das Prozessgas und das Gas mit dem die Bernoulli-Greifer betrieben werden, identisch sein. Das Gas kann vorgewärmt oder auch im Kreislauf gefahren werden, wodurch Temperaturprobleme vermieden werden können. Hierfür geeignet sind beispielsweise handelsübliche Graphitpumpen.

In einer weiteren Ausgestaltung der Erfindung weisen die Bernoulli-Greifer eine topfähnliche Gestalt auf, wobei auf deren inneren Seitenwand mindestens eine Ausströmöffnung für Druckluft oder ein anderes Gas in tangentialer Richtung angeordnet ist.

Die Ausströmöffnung kann auch eine leichte Winkelanstellung nach oben aufweisen, d.h. in Richtung zu den zu transportierenden Substraten, so dass ein deutlich aufwärts gerichteter und sich spiralig drehender Gasstrom entsteht.

Um einen besonders gleichmäßigen Gasstrom zu erreichen, ist es von Vorteil, wenn jeweils zwei einander gegenüber liegende und gleichsinnig ausgerichtete Ausströmöffnungen in der inneren Seitenwand jedes Bernoulli-Greifers vorgesehen sind.

Schließlich kann in der inneren Seitenwand ein weiteres Paar von Ausströmöffnungen mit entgegen gesetzter Ausrichtung angeordnet sein, um bei entsprechender Beaufschlagung mit einem unter Druck stehenden Gas eine umschaltbare Drehrichtung der Gasströmung zu realisieren.

Die erfindungsgemäße Anordnung lässt sich ohne weiteres auch für den Über-Kopf-Transport mit hängenden Substraten einsetzen.

Bei hängendem Transport kann das Substrat besonders einfach von einer Unterlage übernommen/angesaugt werden. Das Substrat muss dazu entsprechend nahe an die Bernoulli-Greifer herangefahren/bewegt werden, bis der Bernoulli-Effekt einsetzt.

Es ist ein problemloser bergauf Transport der Substrate bis zu einer Steigung von etwa 30° möglich. Bergab müsste dann die bereits beschriebene Bremswirkung ausgenutzt werden.

Die Erfindung soll nachfolgend an einem Ausführungsbeispiel näher erläutert werden.

In den zugehörigen Zeichnungsfiguren zeigen:
- Fig. l:: eine schematische perspektivische Darstellung einer erfindungsgemäßen Vorrichtung zum berührungslosen Transport von flachen Substraten;

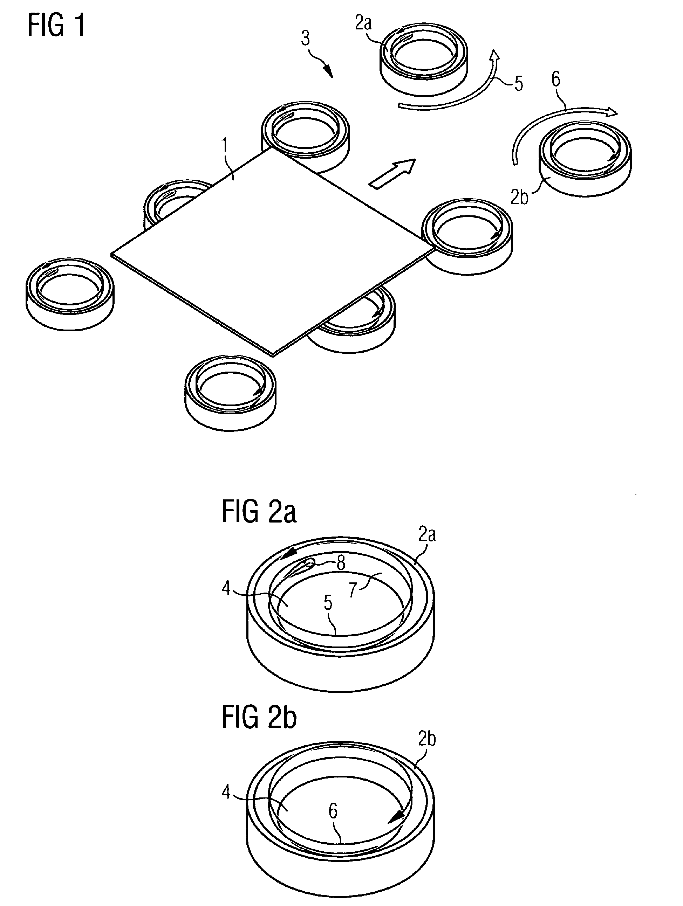

- Fig. 2a:: einen Bernoulli-Greifer mit links drehender Gasströmung; und
- Fig. 2b:: einen Bernoulli-Greifer mit rechts drehender Gasströmung.

Fig. 1 zeigt eine schematische Darstellung einer erfindungsgemäßen Vorrichtung zum berührungslosen Transport von flachen Substraten 1 in Form von quadratischen oder eckigen Platten hoher Bruchempfindlichkeit, beispielsweise von Substraten für Solarzellen, entlang eines Transportweges 3 mit zwei Reihen von topfförmigen Bernoulli-Greifern 2a, 2b seitlich des Transportweges 3.

Der Abstand der Bernoulli-Greifer 2a, 2b zueinander rechts und links des Transportweges 3 ist größer, als die Breite der Substrate 1 und zwar derart, dass die Substrate 1 bei der Vorbeibewegung etwa maximal die Hälfte der Öffnung 4 des jeweiligen Bernoulli-Greifers 2a, 2b überdecken. Die Bernoulli-Greifer 2a der linken Reihe erzeugen hier einen links drehenden Gasstrom 5 und die Bernoulli-Greifer 2b der rechten Reihe eine rechts drehende Luftströmung 6, jeweils in Richtung zum zu transportierenden Substrat und gleichzeitig in Transportrichtung 3.

Als Substrate 1 kommen auch texturierte Wafer in Betracht, wobei diese einfach auf der texturierten Seite gegriffen werden können.

Die Bernoulli-Greifer 2a, 2b können dabei auf einer Unterlage aus einem beliebigen Material angeordnet oder in diese z.B. flächenbündig eingelassen bzw. eingepresst sein. Als Unterlage kann auch eine Graphitplatte verwendet werden, wodurch ein sicherer Einsatz auch bei höheren Temperaturen bis. ca. 1000 °C gewährleistet wird. Die Unterlage und die Bernoulli-Greifer 2a, 2b können auch aus einem anderen thermisch belastbaren und hinreichend chemisch resistenten Material, wie z.B. Keramik, bestehen.

Fig. 2a zeigt einen Bernoulli-Greifer 2a mit links drehender Gasströmung 5 und Fig. 2b einen Bernoulli-Greifer 2b mit rechts drehender Gasströmung 6.

Einzelheiten der Bernoulli-Greifer 2a, 2b sind aus Fig. 2 ersichtlich. Diese haben eine topfähnliche Gestalt mit einer Öffnung 4 in Richtung zum zu transportierenden Substrat 1 und sind auf der inneren Seitenwand 7 mit mindestens einer Ausströmöffnung 8 (Düse) in tangentialer Richtung für Druckluft oder ein anderes Gas, z.B. ein Prozessgas ausgestattet. Die Düse 8 kann eine leichte Winkelanstellung nach oben in Richtung zur Öffnung 4 aufweisen, so dass ein aufwärts gerichteter sich spiralig drehender Gasstrom 5; 6 entsteht.

Wenn die Bernoulli-Greifer komplett aus Graphit gefertigt werden, können diese problemlos bei Temperaturen um 1000 °C und auch in einer H2-Atmosphäre betrieben werden. Hierbei können das Prozessgas und das Gas mit dem die Bernoulli-Greifer betrieben werden, identisch sein. Das Gas kann vorgewärmt oder auch im Kreislauf gefahren werden, wodurch Temperaturprobleme vermieden werden können. Hierfür geeignet sind beispielsweise handelsübliche Graphitpumpen.

Vorzugsweise sind zwei einander gegenüber liegende gleichsinnig ausgerichtete Ausströmöffnungen 8 in der inneren Seitenwand 7 jedes Bernoulli-Greifers 2a, 2b vorgesehen, wodurch ein gleichmäßigerer Gasstrom 5; 6 erreicht wird.

Um unterschiedliche Drehrichtungen der Gasströmung 5, 6 mit dem gleichen Bernoulli-Greifer 2a; 2b zu realisieren, kann zusätzlich in der inneren Seitenwand 7 ein weiteres Paar von Ausströmöffnungen (nicht dargestellt) vorgesehen sein, die dann bei einer entsprechenden Ansteuerung eine entgegen gesetzte Drehrichtung der Gasströmung erzeugen.

Die links des Transportweges 3 angeordneten Bernoulli-Greifer 2a erzeugen einen links drehenden Gasstrom 5 und die rechts des Transportweges 3 angeordneten Bernoulli-Greifer 2b einen rechts drehenden Gasstrom 6, so dass ein gegriffenes Substrat 1, welches dazu unmittelbar über den Bernoulli-Greifern positioniert werden muss, wie in der Fig. 1 dargestellt, dann auf dem Luftpolster "schwimmt" und durch eine durch die Gasströmung in Verbindung mit der Oberflächenrauhigkeit der Substrate 1 erzeugten Vortriebskraft längs des Transportweges 3 vorwärts transportiert wird.

Unter rechts drehend soll im Uhrzeigersinn und unter links drehend im Gegenuhrzeigersinn drehend verstanden werden.

Sollen Transporte entlang des Transportweges 3 in beiden Richtungen realisiert werden, so können die bereits beschriebenen in der Drehrichtung des Gasstromes umschaltbaren Bernoulli-Greifer eingesetzt werden.

Die andere Möglichkeit besteht darin, rechts und links des Transportweges 3 abwechselnd Bernoulli-Greifer 2a, 2b mit rechts und links drehendem Gasstrom anzuordnen, wobei die längs des Transportweges 3 paarweise einander gegenüberliegenden Bernoulli-Greifer 2a, 2b jeweils die entgegen gesetzte Drehrichtung aufweisen müssen, ebenso wie die längs des Transportweges 3 beidseitig hintereinander befindlichen Bernoulli-Greifer 2a, 2b.

Damit erzeugt jedes zweite Paar der Bernoulli-Greifer 2a, 2b eine Vortriebskraft in die gleiche Richtung. So kann auf einfache Weise durch Umschalten der Ausströmöffnungen 8 der Paare gleicher Transportrichtung eine Umkehr der Transportrichtung erreicht werden.

Es ist auch möglich, die Transportgeschwindigkeit gegen Ende des Transportweges zu reduzieren, indem dort Paare von Bernoulli-Greifern 2a, 2b mit entgegen gesetzter Vortriebsrichtung zur Erzeugung einer Bremswirkung vorübergehend zugeschaltet werden.

Sollen besonders große Substrate transportiert werden, können weitere Bernoulli-Greifer 2a; 2b als Mittenunterstützung mittig des Transportweges 3 angeordnet werden. Diese weiteren Bernoulli-Greifer 2a; 2b müssen nicht zwangsläufig einen sich spiralig drehenden Luftstrom 5; 6 erzeugen. Den Vortrieb übernehmen dann ebenfalls die am Rande des Transportweges 3 befindlichen Bernoulli-Greifer wie bereits beschrieben, die dann nur weiter auseinander angeordnet sind.

Selbst Kurven können gefahren werden, indem dem kurveninneren Bernoulli-Greifer mehrere kurvenäußere Bernoulli-Greifer mit entgegen gesetzter Drehrichtung zugeordnet werden.

Die besonderen Vorteile der Erfindung sind darin zu sehen, dass diese in verschiedenen Atmosphären eingesetzt werden kann, also bei hohen und tiefen Temperaturen sowie auch unter aggressiven Atmosphären.

Durch eine gezielte Werkstoffwahl für die Bernoulli-Greifer kann die erfindungsgemäße Anordnung auch bei besonders hohen Temperaturen eingesetzt werden. So lässt sich Graphit als Material für die Bernoulli-Greifer unter Sauerstoffatmosphäre bis zu 500 °C einsetzen.

### Bezugszeichenliste

- 1: Substrat
- 2a: Bernoulli-Greifer
- 2b: Bernoulli-Greifer
- 3: Transportweg
- 4: Öffnung
- 5: links drehender Gasstrom
- 6: rechts drehender Gasstrom
- 7: innere Seitenwand
- 8: Ausströmöffnung

## Patentansprüche

1. Anordnung zum berührungslosen Transport von flachen Substraten in Form von quadratischen oder eckigen Platten hoher Bruchempfindlichkeit entlang eines Transportweges, **dadurch gekennzeichnet, dass** eine Mehrzahl von Bernoulli-Greifern (2a, 2b) beidseitig eines Transportweges (3) abstandsweise hintereinander und paarweise quer zur Transportrichtung einander gegenüberliegend angeordnet sind, dass die zu transportierenden Substrate (1) bei deren Vorbeibewegung derart über den Bernoulli-Greifern (2a, 2b) positionierbar sind, dass diese beidseitig des Transportweges (3) jeweils nur teilweise überdeckt sind, dass die Bernoulli-Greifer (2a, 2b) jeweils einen rechts oder links spiralig aufwärts drehenden zum Substrat (1) und in Transportrichtung gerichteten Gasstrom (5, 6) mit einer Drehachse senkrecht zur Unterlage erzeugen, wobei die Bernoulli-Greifer (2a, 2b) eines Paares jeweils einen unterschiedlich drehenden Gasstrom (5, 6) erzeugen und dass beidseitig des Transportweges (3) mechanische Seitenführungselemente vorgesehen sind.

2. Anordnung nach Anspruch 1, **dadurch gekennzeichnet, dass** als die Seitenführungselemente Schienen oder Begrenzungsleisten vorgesehen sind.

3. Anordnung nach Anspruch 1 und 2, **dadurch gekennzeichnet, dass** die beidseitig längs des Transportweges (3) aufeinander folgenden Bernoulli-Greifer (2a, 2b) abwechselnd zur Ausbildung von rechts oder links drehenden Gasströmen (5, 6) ausgebildet sind.

4. Anordnung nach den Ansprüchen 1 bis 3, **dadurch gekennzeichnet, dass** jeder Bernoulli-Greifer (2a, 2b) derart umschaltbar ist, dass er nacheinander rechts und links drehende Gasströmungen (5; 6) erzeugt.

5. Anordnung nach einem der Ansprüche 1 bis 4, **dadurch gekennzeichnet, dass** am Ende des Transportweges (3) Bernoulli-Greifer (2a; 2b) mit einer den übrigen Bernoulli-Greifern entgegen gesetzten Vortriebsrichtung angeordnet sind.

6. Anordnung nach einem der Ansprüche 1 bis 5, **dadurch gekennzeichnet, dass** die Bernoulli-Greifer (2a, 2b) auf einer flächigen Unterlage angeordnet sind.

7. Anordnung nach Anspruch 6, **dadurch gekennzeichnet, dass** die Bernoulli-Greifer (2a, 2b) in die Unterlage flächenbündig eingelassen bzw. eingepresst sind.

8. Anordnung nach Anspruch 6 oder 7, **dadurch gekennzeichnet, dass** die Bernoulli-Greifer (2a, 2b) und die Unterlage aus Graphit bestehen.

9. Anordnung nach einem der Ansprüche 1 bis 8, **dadurch gekennzeichnet, dass** die Bernoulli-Greifer (2a, 2b) eine topfähnliche Gestalt aufweisen und dass auf deren inneren Seitenwand (7) mindestens eine Ausströmöffnung (8) für Druckluft oder ein anderes Gas in tangentialer Richtung angeordnet ist.

10. Anordnung nach Anspruch 9, **dadurch gekennzeichnet, dass** die Ausströmöffnung (8) mit leichter Winkelanstellung nach oben zur Öffnung (4), d.h. in Richtung zu den zu transportierenden Substraten (1), angeordnet ist, so dass ein aufwärts gerichteter sich spiralig drehender Gasstrom (5, 6) entsteht.

11. Anordnung nach Anspruch 9 und 10, **dadurch gekennzeichnet, dass** jeweils zwei einander gegenüber liegende gleichsinnig ausgerichtete Ausströmöffnungen (8) in der inneren Seitenwand (7) jedes Bernoulli-Greifers (2a, 2b) vorgesehen sind.

12. Anordnung nach einem der Ansprüche 9 bis 11, **dadurch gekennzeichnet, dass** in der inneren Seitenwand (7) ein weiteres Paar von Ausströmöffnungen (8) mit entgegen gesetzter Ausrichtung angeordnet ist.

## Claims

1. Arrangement for the contactless transport of planar substrates in the form of highly fragile square or angular plates along a transport path, **characterised in that** a plurality of Bernoulli grippers (2a, 2b) are arranged on both sides of a transport path (3) at intervals one behind the other and in opposing pairs transversely to the transport direction, and **in that**, as they move along, the substrates (1) to be transported are positionable over the Bernoulli grippers (2a, 2b) in such a way that on both sides of the transport path (3) each of the said Bernoulli grippers is covered only in part, and **in that** each of the Bernoulli grippers (2a, 2b) generates a gas stream (5, 6) that rotates upwards and spirally to the right or to the left and is directed towards the substrate (1) and in the transport direction, which gas stream has an axis of rotation which is perpendicular to the base, the Bernoulli grippers (2a, 2b) of a pair each generating a differently rotating gas stream (5, 6), and **in that** mechanical lateral guide elements are provided on both sides of the transport path (3).

2. Arrangement according to claim 1, **characterised in that** rails or delimiting strips are provided as the lateral guide elements.

3. Arrangement according to either claim 1 or claim 2, **characterised in that** the Bernoulli grippers (2a, 2b), which are in a longitudinal row along both sides of the transport path (3), are formed alternately for forming right- or left-rotating gas streams (5, 6).

4. Arrangement according to any one of claims 1 to 3, **characterised in that** each Bernoulli gripper (2a, 2b) is switchable in such a way that it generates right- and left-rotating gas streams (5, 6) in succession.

5. Arrangement according to any one of claims 1 to 4, **characterised in that** Bernoulli grippers (2a, 2b), with a propulsion direction which runs opposite to the other Bernoulli grippers, are arranged at the end of the transport path (3).

6. Arrangement according to any one of claims 1 to 5, **characterised in that** the Bernoulli grippers (2a, 2b) are arranged on a planar base.

7. Arrangement according to claim 6, **characterised in that** the Bernoulli grippers (2a, 2b) are inserted or pressed flush into the base.

8. Arrangement according to either claim 6 or claim 7, **characterised in that** the Bernoulli grippers (2a, 2b) and the base consist of graphite.

9. Arrangement according to any one of claims 1 to 8, **characterised in that** the Bernoulli grippers (2a, 2b) have a cup-like configuration and **in that**, on an inner side wall (7) thereof, at least one outlet opening (8) for compressed air or another gas is arranged in the tangential direction.

10. Arrangement according to claim 9, **characterised in that** the outlet opening (8) is arranged at a slight angle upwards towards the opening (4), that is in the direction of the substrates (1) to be transported, so that an upwardly directed, spirally rotating gas stream (5, 6) is formed.

11. Arrangement according to either claim 9 or claim 10, **characterised in that** two mutually opposed outlet openings (8), oriented in the same direction, are provided respectively in the inner side wall (7) of each Bernoulli gripper (2a, 2b).

12. Arrangement according to any one of claims 9 to 11, **characterised in that** a further pair of outlet openings (8), oriented in the opposite direction, are arranged in the inner side wall (7).

## Revendications

1. Dispositif destiné au transport sans contact de substrats plats sous forme de plaques rectangulaires ou angulaires très sensibles à la rupture le long d'une voie de transport,
**caractérisé en ce que**
plusieurs pinces de Bernoulli (2a, 2b) sont montées de part et d'autre d'une voie de transport (3), à distance les unes derrière les autres et se faisant face par paire transversalement à la direction de transport, **en ce que** les substrats (1) à transporter peuvent être positionnés, lors de leur déplacement devant les pinces de Bernoulli (2a, 2b) sur ces pinces, de sorte que celles-ci ne soient respectivement que partiellement recouvertes, de part et d'autre de la voie de transport (3), **en ce que** les pinces de Bernoulli (2a, 2b) produisent respectivement un flux gazeux (5, 6) tournant en spirale vers le haut, vers la droite ou vers la gauche par rapport au substrat, dirigé dans le sens de transport, et ayant un axe de rotation perpendiculaire au support, les pinces de Bernoulli (2a, 2b) d'une paire produisant respectivement des flux gazeux (5, 6) tournant en sens opposés, et, **en ce que** des éléments de guidage latéral mécaniques sont montés de part et d'autre de la voie de transport (3).

2. Dispositif conforme à la revendication 1,
**caractérisé en ce que**
les éléments de guidage latéral sont constitués par des rails ou des barres de limitation.

3. Dispositif conforme aux revendications 1 et 2,
**caractérisé en ce que**
les pinces de Bernoulli (2a, 2b) se succédant de part et d'autre le long de la voie de transport (3), sont conformées pour former alternativement des flux gazeux (5, 6) tournant vers la droite ou vers la gauche.

4. Dispositif conforme à l'une des revendications 1 à 3,
**caractérisé en ce que**
chacune des pinces de Bernoulli (2a, 2b) peut être commutée de façon à produire successivement des flux gazeux (5, 6) tournant vers la droite et vers la gauche.

5. Dispositif conforme à l'une des revendications 1 à 4,
**caractérisé en ce qu'**
à l'extrémité de la voie de transport (3), sont montées des pinces de Bernoulli (2a, 2b) ayant une direction d'avancement inverse de celle des autres pinces de Bernoulli.

6. Dispositif conforme à l'une des revendications 1 à 5,
**caractérisé en ce que**
les pinces de Bernoulli (2a, 2b) sont montées sur un support plan.

7. Dispositif conforme à la revendication 6,
**caractérisé en ce qu'**
les pinces de Bernoulli (2a, 2b) sont insérées ou enfoncées dans le support, à fleur de celui-ci.

8. Dispositif conforme à la revendication 6 ou 7,
**caractérisé en ce que**
les pinces de Bernoulli (2a, 2b) et le support sont réalisés en graphite.

9. Dispositif conforme à l'une des revendications 1 à 8,
**caractérisé en ce que**
les pinces de Bernoulli (2a, 2b) ont la même configuration au niveau de leur partie supérieure et **en ce que**, sur leur paroi latérale interne (7) est disposée au moins une ouverture d'émission (8) d'air comprimé ou d'un autre gaz en direction tangentielle.

10. Dispositif conforme à la revendication 9,
**caractérisé en ce que**
l'ouverture d'émission (8) est légèrement inclinée angulairement vers le haut par rapport à l'ouverture (4), c'est-à-dire en direction des substrats (1) à transporter de façon à créer un flux gazeux (5, 6) tournant en spirale dirigé vers le haut.

11. Dispositif conforme aux revendications 9 et 10,
**caractérisé en ce qu'**
il est respectivement prévu deux ouvertures d'émission (8) situées en regard et dirigées dans le même sens dans la paroi latérale interne (7) de chacune des pinces de Bernoulli (2a, 2b).

12. Dispositif conforme à l'une des revendications 9 à 11,
**caractérisé en ce qu'**
une autre paire d'ouvertures d'émission (8) d'orientation opposée, est disposée dans la paroi latérale interne (7).
